# EUROPÄISCHE PATENTSCHRIFT

(11) **EP 0 986 176 B1**
(45) Veröffentlichungstag und Bekanntmachung des Hinweises auf die Patenterteilung: **25.02.2004**
(21) Anmeldenummer: 99116557.2
(22) Anmeldetag: 24.08.1999
(51) Int. Cl.: H03K 17/97, G08B 13/08, G08B 13/24

(54) **Berührungsloser Sicherheitsschalter**
Contactless security switch
Commutateur de sécurité sans contact

(30) Priorität: 05.09.1998 DE 19840620
(43) Veröffentlichungstag der Anmeldung: 15.03.2000
(73) Patentinhaber: steute Schaltgeräte GmbH & Co. KG, 32584 Löhne (DE)
(72) Erfinder: Heuer, Friedhelm, 32361 Pr. Oldendorf (DE); Kuhlmann, Thomas, 32120 Hiddenhausen (DE)
(74) Vertreter: Sparing Röhl Henseler Patentanwälte

(56) Entgegenhaltungen:
- DE-A- 2 033 682
- DE-A- 3 029 543
- DE-A- 4 112 064
- DE-A- 4 113 665

## Beschreibung

Die Erfindung betrifft einen berührungslosen Sicherheitsschalter nach dem Oberbegriff des Anspruchs 1.

Sicherheitsschalter oder -sensoren dienen zum Feststellen der Schließstellung von schließenden Teilen, beispielsweise von Türen oder Verschlußklappen, gegenüber verschließbaren Teilen; etwa mit entsprechenden Zutrittsöffnungen versehene Begrenzungs-, Gehäusewände und dergleichen, und arbeiten aus Sicherheitsgründen mit einem speziellen Betätiger zusammen, so daß ihre Auslösestellung nicht durch einfache Werkzeuge o. dgl. manipulierbar ist. Solche Sicherheitsschalter umfassen im allgemeinen eine Schaltereinheit und einen Auslöser, wobei jeweils eine dieser Komponenten an dem verschließbaren Teil und die andere an dem schließbaren Teil angeordnet ist. Hierbei-sind Sicherheitsschalter mit mechanischer oder mit magnetischer, also berührungsfreier Kopplung zwischen Schaltereinheit und Auslöser bekannt.

Im Falle einer mechanischen Kopplung ist eine genaue Ausrichtung mit geringen Toleranzen erforderlich, wodurch eine Justierung erschwert wird. Da mechanische Vorrichtungen nicht berührungsfrei arbeiten, sind sie nur schwierig keimfrei zu halten, was etwa für Anwendungsbereiche im Lebensmittelsektor wichtig ist.

Berührungslose Sicherheitsschalter sind auf der Basis von verschalteten Reedkontakten bekannt. Da Reedkontakte jedoch bei größeren Strömen oder kapazitiven Lasten verschweißen, ist die Zuverlässigkeit solcher Sicherheitsschalter häufig nicht ausreichend, und sie benötigen zudem spezielle Auswerteeinheiten.

Aus DE-C-4 112 064 ist eine Alarmgeberanordnung mit einer Schaltereinheit bekannt, die einen Sendekreis mit einem Oszillator und einer Sendespule und einen mit einer Diskriminatorschaltung verbundenen Empfängerkreis mit mindestens einer Empfängerspule aufweist. Hierbei wird eine kontinuierliche Energieübertragung auch bei erfolgender Signalübertragung sichergestellt. Allerdings bietet eine derartige Anordnung nicht immer den geforderten Sicherheitsstandard.

Aus DE-C-3 029 543 ist es auf dem Gebiet der Melde- und Überwachungstechnik bekannt, eine Primäreinheit in Form einer Schaltereinheit die verwenden, die einen Sendekreis mit einem Oszillator und einer Sendespule und einen mit einer Auswerteeinheit verbundenen Empfängerkreis mit mindestens einer Empfängerspule besitzt und mit einer Sekundäreinheit, einem Auslöser, zusammenarbeitet. Die Sekundäreinheit umfaßt eine Empfängerspule und eine von der Sendespule der Primäreinheit gesteuerte Auslöserspule, die in Schließstellung ein Meldesignal auslöst. Dabei wird von der Primäreinheit zur Sekundäreinheit eine erste Frequenz und in umgekehrter Richtung eine zweite Frequenz übertragen. Allerdings bietet auch eine derartige Anordnung nicht immer den geforderten Sicherheitsstandard.

Aus DE-A-2 033 682 ist eine Anschlußvorrichtung für elektrische Geräte bekannt, mit der ein batteriegespeistes mit einem netzgespeisten Gerät zur Signal- bzw. Energieübertragung gegenseitig in Anlage gebracht wird. Dabei schließt jeweils ein Permanentmagnet im einen Gerät einen Schutzrohrankerkontakt im anderen Gerät. Für die Signalübertragung und für die Energieübertragung ist je Gerät jeweils eine eigne Spule mit U-förmigem Kern vorgesehen.

Aus- DE-A-4 113 665 ist eine fremdfeldsichere Kontaktanordnung von magnetisch betätigten Schaltelementen zur Überwachung des Schließzustandes von Fenstern und Türen bekannt, wobei ein Dauermagnet an einem Fensterflügel oder einer Türe und mindestens zwei magnetfeldbetätigte Schaltelemente an dem Fenster- bzw. Türrahmen angebracht sind. Hierbei ergibt sich das oben erwähnte Problem des Verschweißens von Kontakten der magnetisch betätigten Schaltelemente.

Aufgabe der Erfindung ist es, einen berührungslosen Sicherheitsschalter nach dem Oberbegriff des Anspruchs 1 zu schaffen, der eine erhöhte Zuverlässigkeit aufweist.

Diese Aufgabe wird entsprechend dem kennzeichnenden Teil des Anspruchs 1 gelöst.

Dadurch, daß in einem Sicherheitsschalter mit einer Schaltereinheit und einem einen Magneten umfassenden Auslöser die Schaltereinheit einen Sendekreis mit einem Taktsignalgenerator und einer Sendespule, einen mit einer Auswerteeinheit verbundenen Empfängerkreis mit mindestens einer Empfängerspule sowie einen auf den Magneten ansprechenden Hallsensor und der Auslöser eine in Schließstellung von der Sendespule induktiv erregbare und die Empfängerspule erregende Auslöserspule umfaßt, wobei in Schließstellung die Auswerteeinheit nach einem Vergleich der gesendeten und empfangenen Taktsignale einen Freigabepfad ansteuert, wenn der Hallsensor über den Magneten aktiviert ist, kann kein Verschweißen bei größeren Strömen oder kapazitiven Lasten auftreten, so daß die Zuverlässigkeit erhöht wird.

Vorzugsweise sind der Auswerteeinheit in Schließstellung zwei Signale zuführbar, wobei die Auswerteeinheit den Freigabepfad nur ansteuert, wenn beide Signale vorliegen. In diesem Fall ist für eine Freigabe eines schließenden Teils gegenüber einem verschließbaren Teil das Erfüllen zweier Bedingungen erforderlich. Das Vorliegen zweier Signale in der Auswerteeinheit ist redundant, weil die Zuführung nur eines Signals zur Auswerteeinheit keinen Verlust an Information hinsichtlich der Annäherung des Auslösers bedeuten würde. Durch die redundante Bauweise wird in Bezug auf die Betätigung des Sicherheitsschalters die Zuverlässigkeit weiter erhöht.

Weitere Ausgestaltungen der Erfindung sind der nachfolgenden Beschreibung und den Unteransprüchen zu entnehmen.

Die Erfindung wird nachstehend anhand von in den beigefügten Abbildungen dargestellten Ausführungsbeispielen näher erläutert.
Fig. 1 zeigt ein Blockschaltbild eines berührungslosen Sicherheitsschalters in einer ersten Ausführungsform.
Fig. 2 zeigt ein Blockschaltbild eines berührungslosen Sicherheitsschalters in einer zweiten Ausführungsform.
Fig. 3 zeigt ein Blockschaltbild eines berührungslosen Sicherheitsschalters in einer dritten Ausführungsform.

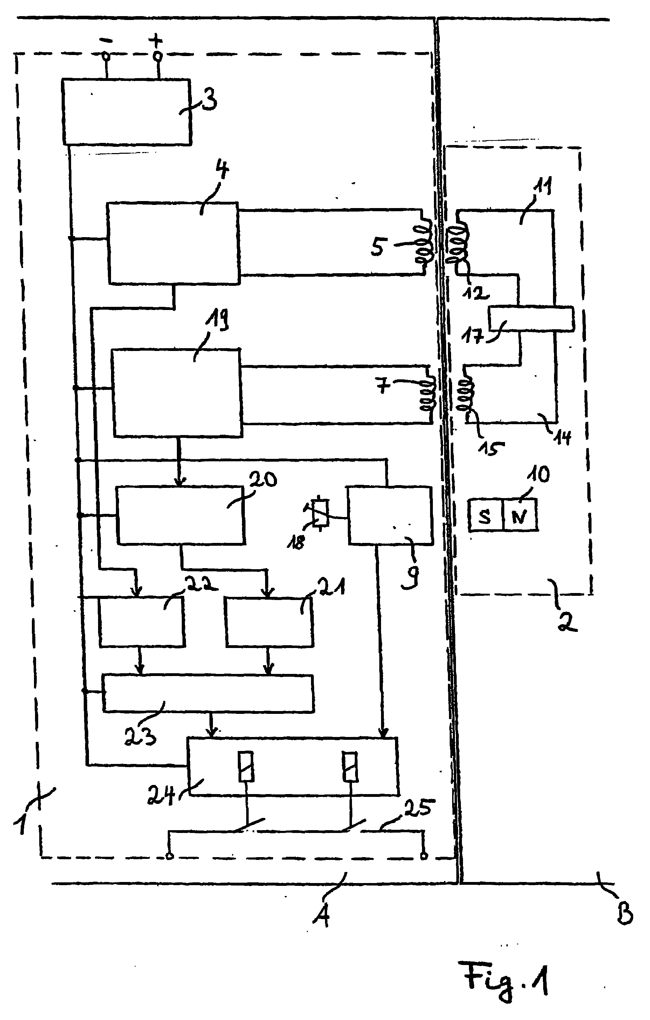

Gemäß Fig. 1 besitzt ein Sicherheitsschalter in einer ersten Ausführungsform eine in einem Gehäuse untergebrachte Schaltereinheit 1 (beispielsweise ein an ein Stromnetz angeschlossenes Netzteil) und einen ebenfalls in einem Gehäuse untergebrachten Auslöser 2, die jeweils an einem verschließbaren Teil A bzw. einem schließenden Teil B angeordnet sind. Vorzugsweise ist die Schaltereinheit 1 an dem verschließbaren Teil A und der Auslöser 2 an dem schließenden Teil B angeordnet.

Die Schaltereinheit 1 wird von einer elektrischen Versorgungsquelle 3 stromversorgt und umfaßt einen Sendekreis mit einem Taktsignalgenerator 4 zum Erzeugen eines Taktsignals sowie eine Sendespule 5. Die Schaltereinheit 1 umfaßt ferner einen Empfängerkreis mit einer Empfängerspule 7 sowie einen Hallsensor 9.

Der Auslöser 2 umfaßt einen Magneten 10, welcher in Schließstellung benachbart zum Hallsensor 9 angeordnet ist. Der Magnet 10 kann ein Permanentmagnet sein. Ferner umfaßt der Auslöser 2 einen Auslöserempfängerkreis 11 mit einer Auslöserspule 12 sowie einen Auslösersendekreis 14 mit einer Spule 15. Die Spulen 12 und 15 sind so angeordnet, daß sie in Schließstellung jeweils im wesentlichen benachbart zur Sendespule 5 bzw. zur Empfängerspule 7 liegen. Der Auslöserempfängerkreis 11 ist somit über die Auslöserspule 12 an die Sendespule 5 des Sendekreises induktiv koppelbar, wobei eine induktive Kopplung eintritt, sobald Sendespule 5 und Auslöserspule 12 benachbart sind. Der Auslösersendekreis 14 ist an den Auslöserempfängerkreis 11 über einen Modifizierkreis 17 gekoppelt.

Bei Annäherung des Auslösers 2 an die Schaltereinheit 1 wird der Hallsensor 9 aktiviert, wenn das durch den Magneten 10 am Ort des Hallsensors 9 erzeugte Magnetfeld zur Auslösung des Hallsensors 9 ausreicht. Vorzugsweise ist der Hallsensor 9 über einen Trimmwiderstand 18 abgleichbar, so daß durch Justierung seiner Schaltschwelle der Abstand zwischen Schaltereinheit 1 und Auslöser 2, bei dem der Hallsensor 9 auslöst, festgelegt werden kann. Außerdem induziert bei Annäherung des Auslösers 2 an die Schaltereinheit 1 die Sendespule 5 infolge der dann einsetzenden induktiven Kopplung zum Auslöserempfängerkreis 11 in diesem eine Spannung, welche durch den Modifizierkreis 17 modifiziert wird. Der Modifizierkreis 17 kann insbesondere einen Frequenzteiler umfassen, welcher die Frequenz des Taktsignals um einen vorbestimmbaren Faktor herunterteilt. Der Auslösersendekreis 14 sendet somit ein modifiziertes Taktsignal aus, wenn der Auslöserempfängerkreis 11 ein Taktsignal vom Sendekreis empfängt. Der Auslösersendekreis 14 ist seinerseits über die Spule 15 an die Empfängerspule 7 des Empfängerkreises induktiv koppelbar, wobei eine induktive Kopplung eintritt, sobald Empfängerspule 7 und Spule 15 benachbart sind. Bei Annäherung des Auslösers 2 an die Schaltereinheit 1 empfängt somit die Empfängerspule 7 das modifizierte Taktsignal. Die Empfängerspule 7 wird mit der Frequenz des modifizierten Taktsignals angeregt.

Gegebenenfalls sind Abschirmungen an Sendespule 5 bzw. Empfängerspule 7 und/oder am Auslöserempfänger- bzw. Auslösersendekreis 11, 14 angebracht, so daß eine unerwünschte Kopplung, etwa zwischen Auslösersendekreis 14 und Sendespule 5, vermieden wird. Alternativ kann auch ein entsprechend kleines Taktsignal gewählt werden, oder es wird ein ausreichend großer Abstand zwischen Sendespule 5 und Empfängerspule 7 bzw. zwischen Auslöserempfängerkreis 11 und Auslösersendekreis 14 vorgesehen.

Der Empfängerkreis enthält auch ein Bandpaßfilter 19. Das Bandpaßfilter 19 ist so ausgelegt, daß es nur das durch den Modifizierkreis 17-modifizierte Taktsignal durchläßt und sonstige Fremdsignale ausfiltert. Es ist über einen Verstärker 20 zur Verstärkung des modifizierten Taktsignals mit einer Impulsformund Zählstufe 21 verbunden, in der das modifizierte Taktsignal aufbereitet und aufaddiert wird.

Der Taktsignalgenerator 4 ist außerdem direkt mit einer weiteren Impulsform- und Zählstufe 22 verbunden. Die Impulsform- und Zählstufe 22 empfängt somit das vom Taktsignalgenerator 4 erzeugte, nicht modifizierte Taktsignal. An die Ausgänge der Impulsform- und Zählstufen 21, 22 ist eine gemeinsame Vergleicherstufe 23 angeschlossen, deren Ausgang auf einen Kanal einer Relaisstufe 24 geführt ist. Ein weiterer Kanal der Relaisstufe 24 ist mit dem Hallsensor 9 verbunden, wobei vom Hallsensor 9 ein Freigabesignal diesem Kanal zugeführt wird, wenn der Hallsensor 9 durch Annäherung des zum Auslöser 2 gehörenden Magneten 10 aktiviert wird. Die Vergleicherstufe 23 bewertet die von den Impulsform- und Zählstufen 21, 22 empfangenen Zählerstände, wobei die Vergleicherstüfe 23 durch das erste ankommende Signal der Zählerstufe 22 aktiviert wird und die Impulsform- und Zählstufen 21, 22 nach mindestens einem geeignet gewählten Zeitintervall oder Zählerstand abfragt.

Bei Verwendung eines Frequenzteilers als Modifizierkreis 17 kann die Vergleicherstufe 23 so ausgelegt sein, daß sie die Zählerstände der Impulsformund Zählstufen 21, 22 nach geeignet gewählten, unterschiedlichen Zeitintervallen oder Zählerständen abfragt, so daß die Impulsform- und Zählstufe 21, die das modifizierte Taktsignal mit einer um einen bestimmten Faktor gegenüber dem vom Taktsignalgenerator 4 erzeugten Taktsignal niedrigeren Frequenz empfängt, erst nach einer um denselben Faktor höheren Zeitspanne oder einem um denselben Faktor kleineren Zählerstand abgefragt wird als die Impulsform- und Zählstufe 22. Die Vergleicherstufe 23 gibt nur dann ein Ausgangssignal an die Relaisstufe 24 aus, wenn die beiden empfangenen Zählerstände in einem vorbestimmten Verhältnis zueinander stehen.

Alternativ können die Zählerstände der Impulsform- und Zählstufen 21, 22 auch gleichzeitig von der Relaisstufe 24 abgefragt werden, wobei dann die Vergleicherstufe 23 so ausgelegt wird, daß sie die Zählerstände der Impulsformund Zählstufen 21, 22 durcheinander dividiert. Sie gibt nur dann ein Ausgangssignal an die Relaisstufe 24 aus, wenn der ermittelte Quotient dem Faktor des Frequenzteilers entspricht. Die Impulsform- und Zählstufen 21, 22 können auch so ausgelegt sein, daß die unterschiedliche Frequenz von vom Taktsignalgenerator 4 erzeugtem und modifiziertem Signal durch unterschiedliche Modulation wieder ausgeglichen wird. Die Vergleicherstufe 23 fragt dann die Zählerstände nach gleichen, geeignet gewählten Zeitspannen ab und gibt nur bei Übereinstimmung ein Ausgangssignal an die Relaisstufe 24.

Die Relaisstufe 24 ist mit einem Freigabepfad 25 verschaltet. Die Relaisstufe 24 ist vorzugsweise eine Sicherheitsrelaisstufe, welche zwei Sicherheitsrelais umfaßt.

Eine Durchschaltung des Freigabepfades 25 über die Relaisstufe 24 erfolgt nur, wenn zuvor beide Kanäle der Relaisstufe 24 inaktiv waren und anschließend an beiden Kanälen der Relaisstufe 24 jeweils ein Signal vorliegt. Dies setzt sowohl voraus, daß die Vergleicherstufe 23 ein Ausgangssignal erzeugt, als auch, daß der Hallsensor 9 aktiviert ist. Infolgedessen weist der Sicherheitsschalter eine redundante Bauweise auf.

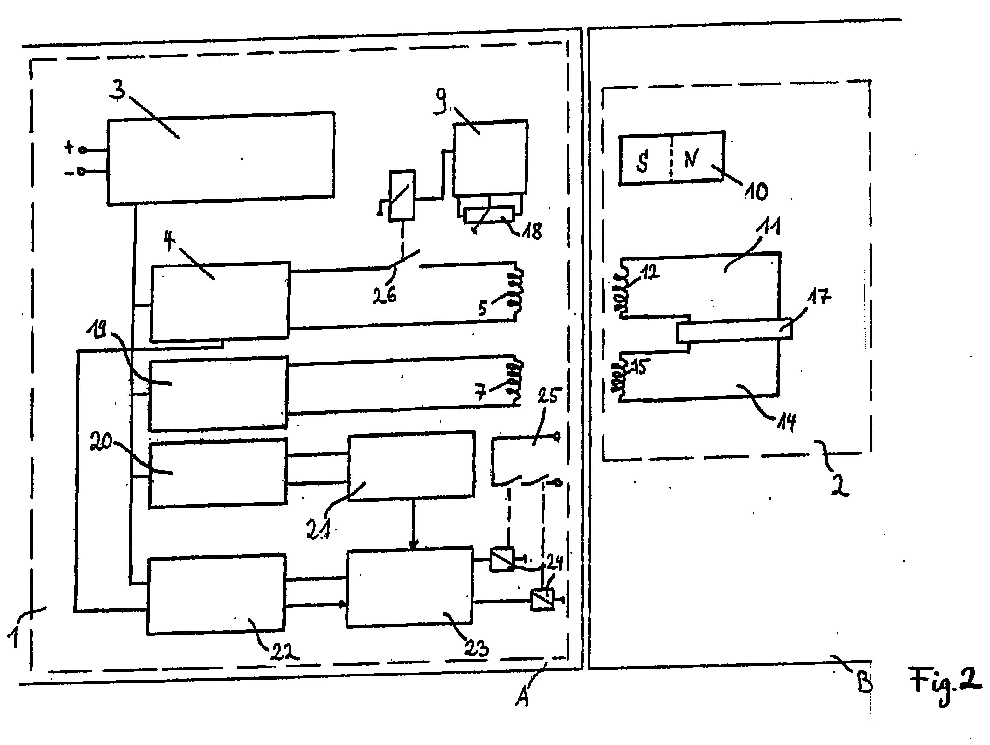

Gemäß Fig. 2 umfaßt in einer zweiten Ausführungsform der Sendekreis der Schaltereinheit 1 einen Schalter 26 zum Schließen bzw. Unterbrechen des Sendekreises, der über den Hallsensor 9 einschaltbar ist. Bei Annäherung des Auslösers 2 an die Schaltereinheit 1 wird somit der Schalter 26 über den Hallsensor 9 eingeschaltet, wenn das durch den Magneten 10 am Ort des Hallsensors 9 erzeugte Magnetfeld zur Auslösung des Hallsensors 9 ausreicht. Auch hier ist der Hallsensor 9 vorzugsweise über einen Trimmwiderstand 18 abgleichbar, so daß durch Justierung seiner Schaltschwelle der Abstand zwischen Schaltereinheit 1 und Auslöser 2, bei dem der Hallsensor 9 auslöst, festgelegt werden kann. Bei Auslösung des Hallsensors 9 wird der Schalter 26 eingeschaltet und damit der Sendekreis geschlossen. Erst dann wird das vom Taktsignalgenerator 4 erzeugte Taktsignal freigegeben, woraufhin analog zu der in Fig. 1 dargestellten Ausführungsform die Sendespule 5 infolge der induktiven Kopplung zum Auslöserempfängerkreis 11 in diesem eine Spannung induziert.

Im übrigen sind der Auslöser 2 sowie die Auswerteeinheit des Sicherheitsschalters genauso wie in der ersten Ausführungsform aufgebaut. Gemäß Fig. 2 wird jedoch in der zweiten Ausführungsform das vom Taktsignalgenerator 4 erzeugte Taktsignal nicht kontinuierlich, sondern nur bei Freigabe durch Aktivierung des Hallsensors 9 der Impulsform- und Zählstufe 22 zugeführt. Ebenso tritt die induktive Kopplung zwischen der Sendespule 5 des Sendekreises und der Auslöserspule 12 des Auslöserempfängerkreises 11 nur dann ein, wenn Sendespule 5 und Auslöserspule 12 benachbart sind und der Sendekreis durch Aktivierung des Hallsensors 9 durch den Magneten 10 geschlossen ist. Bei Annäherung des Auslösers 2 an die Schaltereinheit 1 und geschlossenem Sendekreis wird analog zur ersten Ausführungsform ein durch den zum Auslöser 2 gehörenden Modifizierkreis 17 modifiziertes Taktsignal der Impulsform- und Zählstufe 21 zugeführt. Die Impulsform- und Zählstufen 21, 22 sind analog zur ersten Ausführungsform an die gemeinsame Vergleicherstufe 23 angeschlossen, deren Ausgang mit der Relaisstufe 24 verbunden ist. Der mit der Relaisstufe 24 verschaltete Freigabepfad 25 wird nur dann durch die Relaisstufe 24 durchgeschaltet, wenn die Vergleicherstufe 23 das freigegebene Taktsignal und das durch den Modifizierkreis 17 modifizierte Taktsignal in einem vorbestimmten Frequenzverhältnis empfängt. Die Zuführung eines freigegebenen und eines modifizierten Signals ist redundant, weil die Übertragung nur des freigegebenen Signals keinen Verlust an Information hinsichtlich der Annäherung des Auslösers 2 bedeuten würde. Auch bei dieser Ausführungsform ergibt sich somit durch die redundante Bauweise in bezug auf die Betätigung des Sicherheitsschalters eine erhöhte Zuverlässigkeit.

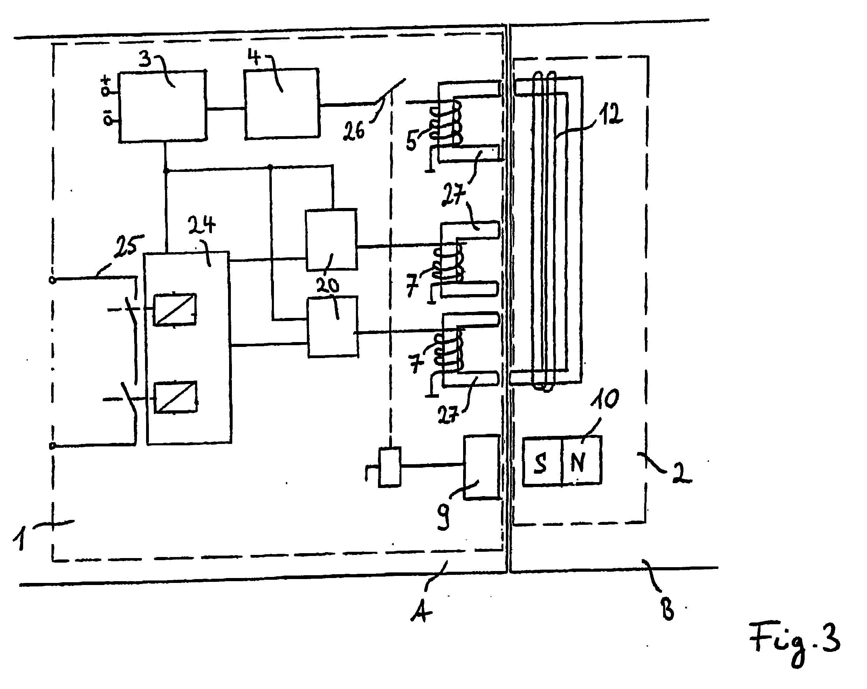

Gemäß Fig. 3 ist in einer dritten Ausführungsform analog zur zweiten Ausführungsform ebenfalls ein Schalter 26 vorgesehen, der bei Auslösung des Hallsensors 9 durch den Magneten 10 das vom Taktsignalgenerator 4 erzeugte Taktsignal freigibt. Der Sendekreis umfaßt analog zu den ersten beiden Ausführungsformen eine Sendespule 5, die hier einen magnetisierbaren U-förmigen Kern 27 aufweist. Der Empfängerkreis umfaßt jedoch zwei Empfängerspulen 7, die ebenfalls jeweils einen magnetisierbaren U-förmigen Kern 27 aufweisen und denen jeweils eine Verstärkerstufe 20 nachgeschaltet ist. Die Ausgänge der Verstärkerstufen 20 sind jeweils direkt mit einem Kanal der Relaisstufe 24 verbunden.

Der Auslöser 2 umfaßt außer dem in Schließstellung benachbart zum Hallsensor 9 angeordneten Magneten 10 lediglich die Auslöserspule 12, welche in Schließstellung benachbart zur Sendespule 5 und zu den beiden Empfängerspulen 7 angeordnet ist. Die Auslöserspule 12 weist ebenfalls einen U-förmigen magnetisierbaren Kern 27 auf.

Im Schließzustand tritt somit sowohl zwischen der Sendespule 5 und der Auslöserspule 12 als auch zwischen der Auslöserspule 12 und den beiden Empfängerspulen 7 eine induktive Kopplung ein. Bei Freigabe des vom Taktsignalgenerator 4 erzeugten Taktsignals induziert somit die Sendespule 5 in der Auslöserspule 12 eine Spannung, die wiederum eine Spannung in den beiden Empfängerspulen 7 erzeugt. Das von den Empfängerspulen 7 empfangene Signal wird über die Verstärkerstufe 20 an die beiden Kanäle der Relaisstufe 24 weitergeleitet. Der mit der Relaisstufe 24 verschaltete Freigabepfad 25 wird analog zu den ersten beiden Ausführungsformen nur dann durchgeschaltet, wenn an beiden Kanälen der Relaisstufe 24 jeweils ein Signal vorliegt. Die Zuführung zweier Signale von den beiden Empfängerspulen 7 an die Relaisstufe 24 ist analog zu den ersten beiden Ausführungsformen redundant, weil die Übertragung nur eines Signals keinen Verlust an Information hinsichtlich der Annäherung des Auslösers 2 bedeuten würde.

## Patentansprüche

1. Berührungsloser Sicherheitsschalter zum Feststellen der Schließstellung eines schließenden Teils (B) gegenüber einem verschließbaren Teil (A), mit einer von einer elektrischen Versorgungsquelle (3) stromversorgten Schaltereinheit (1) an einem der Teile und einem an dem anderen Teil angeordneten, einen Magneten (10) umfassenden Auslöser (2), **dadurch gekennzeichnet, daß** die Schaltereinheit (1) einen Sendekreis mit einem Taktsignalgenerator (4) und einer Sendespule (5), einen mit einer Auswerteeinheit verbundenen Empfängerkreis mit mindestens einer Empfängerspule (7) sowie einen auf den Magneten (10) ansprechenden Hallsensor (9) und der Auslöser (2) eine in Schließstellung von der Sendespule (5) induktiv erregbare und die Empfängerspule (7) erregende Auslöserspule (12) umfaßt, wobei in Schließstellung die Auswerteeinheit nach einem Vergleich der gesendeten und empfangenen Taktsignale einen Freigabepfad (25) ansteuert, wenn der Hallsensor (9) über den Magneten (10) aktiviert ist.

2. Sicherheitsschalter nach Anspruch 1, **dadurch gekennzeichnet, daß** in Schließstellung der Auswerteeinheit zwei Signale zuführbar sind, die den Freigabepfad (25) nur ansteuert, wenn beide Signale in der Auswerteeinheit vorliegen.

3. Sicherheitsschalter nach Anspruch 1 oder 2, **dadurch gekennzeichnet, daß** der Auswerteeinheit eine insbesondere zweikanalige Relaisstufe (24) nachgeschaltet ist, über die der Freigabepfad (25) durchschaltbar ist.

4. Sicherheitsschalter nach einem der Ansprüche 1 bis 3, **dadurch gekennzeichnet, daß** zwei Empfängerspulen (7) vorgesehen sind, die mit der Auslöserspule (12) induktiv koppelbar sind, wobei der Freigabepfad (25) nur dann durchschaltbar ist, wenn von beiden Empfängerspulen (7) jeweils ein Signal geliefert wird und zuvor kein Signal vorlag.

5. Sicherheitsschalter nach einem der Ansprüche 1 bis 4, **dadurch gekennzeichnet, daß** ein über den Hallsensor (9) betätigbarer Schalter (26) im Sendekreis vorgesehen ist, wobei das von dem Taktsignalgenerator (4) erzeugte Taktsignal über den Hallsensor (9) an die Empfängerspule (7) freigebbar ist.

6. Sicherheitsschalter nach einem der Ansprüche 1 bis 5, **dadurch gekennzeichnet, daß** der Sendekreis mit der Auswerteeinheit verbunden ist.

7. Sicherheitsschalter nach einem der Ansprüche 1 bis 6, **dadurch gekennzeichnet, daß** die Empfängerspule (7) mit der Auslöserspule (12) indirekt induktiv koppelbar ist, wobei der Auslöser (2) einen die Auslöserspule (12) umfassenden Auslöserempfängerkreis (11) und einen an diesen gekoppelten, mit der Empfängerspule induktiv koppelbaren Auslösersendekreis (14) umfaßt.

8. Sicherheitsschalter nach Anspruch 7, **dadurch gekennzeichnet, daß** der Auslösersendekreis (14) über einen Modifizierkreis (17) mit dem Auslöserempfängerkreis (11) derart gekoppelt ist, daß der Auslösersendekreis (14) ein modifiziertes Taktsignal aussendet.

9. Sicherheitsschalter nach Anspruch 8, **dadurch gekennzeichnet, daß** ein durch den Taktsignalgenerator (4) erzeugtes Taktsignal und das vom Empfängerkreis empfangene modifizierte Taktsignal der Auswerteeinheit zuführbar sind, die den Freigabepfad (25) ansteuert, wenn die beiden Taktsignale in einem vorbestimmten Frequenzverhältnis stehen.

10. Sicherheitsschalter nach Anspruch 8 oder 9, **dadurch gekennzeichnet, daß** die Auswerteeinheit zwei parallel geschaltete Impulsform- und Zählstufen (21, 22) umfaßt, von denen eine zur Aufbereitung und Addition des durch den Taktsignalgenerator (4) erzeugten Taktsignals und eine zur Aufbereitung und Addition des modifizierten Taktsignals ausgelegt ist.

11. Sicherheitsschalter nach Anspruch 10, **dadurch gekennzeichnet, daß** die Auswerteeinheit eine Vergleicherstufe (23) umfaßt, die den Impulsform- und Zählstufen (21, 22) nachgeschaltet ist und nur ein Ausgangssignal abgibt, wenn die Zählerstände der Impulsform- und Zählstufen (21, 22) in einem vorbestimmten Frequenzverhältnis stehen.

12. Sicherheitsschalter nach Anspruch 11, **dadurch gekennzeichnet, daß** ein über den Hallsensor (9) freigebbares Signal der Relaisstufe (24) über einen Kanal und das Ausgangssignal der Vergleicherstufe (23) der Relaisstufe (24) über einen anderen Kanal zuführbar ist, wobei der Freigabepfad (25) nur dann durch die Relaisstufe (24) durchschaltbar ist, wenn an beiden Kanälen ein Signal vorliegt und zuvor an beiden Kanälen kein Signal vorlag.

13. Sicherheitsschalter nach einem der Ansprüche 5 bis 11, **dadurch gekennzeichnet, daß** das von dem Taktsignalgenerator (4) erzeugte Taktsignal, das über den Hallsensor (9) freigebbar ist, über einen Eingang der Relaisstufe (24) zuführbar ist, und das vom Empfängerkreis empfangene, modifizierte Taktsignal der Relaisstufe (24) über einen anderen Kanal zuführbar ist, wobei der Freigabepfad (25) nur dann durch die Relaisstufe (24) durchschaltbar ist, wenn jeweils an beiden Kanälen ein Signal vorliegt und zuvor an beiden Kanälen kein Signal vorlag.

14. Sicherheitsschalter nach einem der Ansprüche 11 bis 13, **dadurch gekennzeichnet, daß** die Vergleicherstufe (23) so ausgelegt ist, daß sie jeweils nach einem geeignet gewählten, konstanten Zeitintervall die Zählerstände der Impulsform- und Zählstufen (21, 22) abfragt.

15. Sicherheitsschalter nach Anspruch 14, **dadurch gekennzeichnet, daß** die Vergleicherstufe (23) so ausgelegt ist, daß sie ein Ausgabesignal an die Relaisstufe (24) nur ausgibt, wenn die Zählerstände der Impulsform- und Zählstufen (21, 22) sich um einen vorgegebenen Wert unterscheiden.

16. Sicherheitsschalter nach einem der Ansprüche 8 bis 15, **dadurch gekennzeichnet, daß** der Modifizierkreis (17) ein Frequenzteiler ist, welcher ein vom Auslöserempfängerkreis (11) empfangenes Taktsignal um einen vorbestimmten Faktor herunterteilt.

17. Sicherheitsschalter nach Anspruch 16, **dadurch gekennzeichnet, daß** die Impulsform- und Zählstufe (21) erst nach einem um den Faktor des Modifizierkreises (17) längeren Zeitintervall als die Impulsform- und Zählstufe (22) abgefragt wird und die Vergleicherstufe (23) nur ein Ausgangssignal an die Relaisstufe (24) ausgibt, wenn die beiden empfangenen Zählerstände gleich sind.

18. Sicherheitsschalter nach Anspruch 16, **dadurch gekennzeichnet, daß** die Impulsform- und Zählstufen (21, 22) so ausgelegt sind, daß sie die unterschiedliche Frequenz von freigegebenem und modifiziertem Signal durch unterschiedliche Modulation wieder ausgleichen.

19. Sicherheitsschalter nach einem der Ansprüche 8 bis 18, **dadurch gekennzeichnet, daß** der Modifizierkreis (17) so ausgelegt ist, daß die Frequenzdifferenz zwischen dem vom Taktsignalgenerator (4) erzeugten und dem modifizierten Taktsignal relativ zur Frequenz des vom Taktsignalgenerator (4) erzeugten Taktsignals groß ist.

20. Sicherheitsschalter nach einem der Ansprüche 1 bis 19, **dadurch gekennzeichnet, daß** der Empfängerspule (7) ein Bandpassfilter (19) nachgeschaltet ist, welcher nur das gegebenenfalls modifizierte Taktsignal durchläßt.

21. Sicherheitsschalter nach einem der Ansprüche 1 bis 20, **dadurch gekennzeichnet, daß** der Auswerteeinheit mindestens ein Verstärker (20) vorgeschaltet ist.

22. Sicherheitsschalter nach einem der Ansprüche 1 bis 21, **dadurch gekennzeichnet, daß** der Hallsensor (9) abgleichbar ist.

23. Sicherheitsschalter nach einem der Ansprüche 1 bis 22, **dadurch gekennzeichnet, daß** der Magnet (10) ein Permanentmagnet ist.

24. Sicherheitsschalter nach einem der Ansprüche 1 bis 23, **dadurch gekennzeichnet, daß** die Schaltereinheit (1) an dem verschließbaren Teil (A) und der Auslöser (2) an dem schließenden Teil (B) angeordnet ist.

## Claims

1. Contactless safety switch for determining the closed position of a closing part (B) with respect to a closeable part (A), with a switch unit (1) powered by an electrical power supply source (3) on one of the parts and a trip element (2) including a magnet (10) arranged on the other part, **characterised in that** the switch unit (1) includes a transmission circuit with a clock signal generator (4) and a transmission coil (5), a receiver circuit with at least one receiver coil (7) and connected with an evaluation unit and a Hall sensor (9) responding to the magnet (10) and the trip element (2) includes a trip coil (12) which in the closed position can be inductively excited by the transmission coil (5) and exciting the receiver coil (7), whereby in the closed position, the evaluation unit, after comparing the clock signals sent and received, triggers an enabling path (25) when the Hall sensor (9) is activated via the magnet (10).

2. Safety switch according to claim 1, **characterised in that** in the closed position two signals can be fed into the evaluation unit, which only triggers the enabling path (25) when both signals are present in the evaluation unit.

3. Safety switch according to claim 1 or 2, **characterised in that** the evaluation unit is connected in series with a following relay device via which the enabling path is connected, said relay device being especially provided with two channels.

4. Safety switch according to one of claims 1 to 3, **characterised in that** two receiver coils (7) are provided which can be inductively coupled with the trip coil (12), whereby the enabling path (25) only connects through when a signal is delivered by both receiver coils (7) and there was previously no signal present.

5. Safety switch according to one of claims 1 to 4, **characterised in that** a switch (26) actuatable via the Hall sensor (9) is provided in the transmission circuit, whereby the clock signal generated by the clock signal generator (4) is releasable to the receiver coil (7) via the Hall sensor (9).

6. Safety switch according to one of claims 1 to 5, **characterised in that** the transmission circuit is connected with the evaluation unit.

7. Safety switch according to one of claims 1 to 6, **characterised in that** the receiver coil (7) can be indirectly inductively coupled with the trip coil (12), whereby the trip element (2) includes a trip receiver circuit (11) and a trip transmission circuit (14) connected with this, which can be inductively coupled to the receiver coil.

8. Safety switch according to claim 7, **characterised in that** the trip transmission circuit (14) is connected via a modifier circuit (17) with the trip receiver circuit (11) in such a way that the trip transmission circuit (14) transmits a modified clock signal.

9. Safety switch according to claim 8, **characterised in that** the clock signal generated by the clock signal generator (4) and the modified clock signal received by the receiver circuit can be fed to the evaluation unit, which triggers the enabling path (25) when both clock signals are at a pre-defined frequency ratio.

10. Safety switch according to claim 8 or 9, **characterised in that** the evaluation unit comprises two parallel pulse shape and counting stages (21, 22), one of which is designed to process and add the clock signal generated by the clock signal generator (4) and one to process and add the modified clock signal.

11. Safety switch according to claim 10, **characterised in that** the evaluation unit includes a comparator stage (23) which is connected in series to the pulse shape and counting stages (21, 22), and only issues an output signal when the counter levels of the pulse shape and counting stages (21, 22) are at a pre-defined frequency ratio.

12. Safety switch according to claim 11, **characterised in that** a signal from the relay device (24) released by the Hall sensor (9) may be supplied via one channel and the output signal of the comparator stage (23) of the relay device (24) via another channel, whereby the enabling path (25) can then only be connected by the relay device (24) if there is a signal on both channels and there was previously no signal on either channel.

13. Safety switch according to one of claims 5 to 11, **characterised in that** the clock signal generated by the clock signal generator (4) which can be released via the Hall sensor (9) may be supplied via an input of the relay device (24), and the modified clock signal from the relay device (24) received from the receiver circuit may be supplied via another channel, whereby the enabling path (25) can then only be connected by the relay device (24) if there is a signal on both channels and there was previously no signal on either channel.

14. Safety switch according to one of claims 11 to 13, **characterised in that** the comparator stage (23) is designed such that after an appropriately selected, constant time interval it interrogates the respective counter contents of the pulse shape and counting stages (21, 22).

15. Safety switch according to claim 14, **characterised in that** the comparator stage (23) is designed such that it only emits an output signal to the relay device (24) when the counter contents of the pulse shape and counting stages (21, 22) differ from each other by a pre-determined value.

16. Safety switch according to one of claims 8 to 15, **characterised in that** the modifier circuit (17) is a frequency divider, which divides a clock signal received from the release receiver circuit (11) by a pre-determined factor.

17. Safety switch according to claim 16, **characterised in that** the pulse shape and counting stages (21) is interrogated only after a time interval longer than the pulse shape and counting stages (22) by the factor of the modifier circuit (17) and the comparator (23) only emits an output signal to the relay (24) if both counter contents received are equal.

18. Safety switch according to claim 16, **characterised in that** the pulse shape and counting stages (21, 22) are designed such that they rebalance the different frequency of released and modified signal by varying modulation.

19. Safety switch according to one of claims 8 to 18, **characterised in that** the modifier circuit (17) is designed such that the frequency difference between the clock signal generated by the clock signal generator (4) and the modified clock signal is large relative to the frequency of the clock signal generated by the clock signal generator (4).

20. Safety switch according to one of claims 1 to 19, **characterised in that** the receiver coil (7) is connected in series to a band pass filter (19) which only allows through the clock signal, modified as necessary.

21. Safety switch according to one of claims 1 to 20, **characterised in that** at least one amplifier (20) is connected on line side to the evaluation unit.

22. Safety switch according to one of claims 1 to 21, **characterised in that** the Hall sensor (9) is adjustable.

23. Safety switch according to one of claims 1 to 22, **characterised in that** the magnet (10) is a permanent magnet.

24. Safety switch according to one of claims 1 to 23, **characterised in that** the switch unit (1) is arranged on the locking part (A) and the trigger (2) on the closeable part (B).

## Revendications

1. Interrupteur de sécurité sans contact, pour constater la position de fermeture d'une partie (B) en train de se fermer par rapport à une partie verrouillable (A), avec une unité d'interrupteur (1) alimentée en courant par une source d'alimentation électrique (3) sur l'une des parties et un déclencheur (2) comprenant un aimant (10) disposé sur l'autre partie, **caractérisé en ce que** l'unité d'interrupteur (1) comprend un circuit d'émission avec un générateur de signaux cadencés (4) et une bobine d'émission (5), un circuit de réception relié à une unité d'évaluation avec au moins une bobine de réception (7), ainsi qu'un capteur de Hall (9) réagissant à l'aimant (10), et **en ce que** le déclencheur (2) comprend une bobine de déclenchement (12) pouvant être excitée de manière inductive par la bobine d'émission (5) et excitant la bobine de réception (7) dans la position de fermeture, l'unité d'évaluation commandant, dans la position de fermeture, après une comparaison des signaux reçus et envoyés, un circuit de libération (25) lorsque le capteur de Hall (9) est activé par l'intermédiaire de l'aimant (10).

2. Interrupteur de sécurité selon la revendication 1, **caractérisé en ce que**, dans la position de fermeture, deux signaux peuvent être amenés à l'unité d'évaluation qui ne commande le circuit de libération (25) que lorsque les deux signaux sont présents dans l'unité d'évaluation.

3. Interrupteur de sécurité selon la revendication 1 ou 2, **caractérisé en ce qu'**un étage de relais (24) en particulier à deux canaux, par l'intermédiaire duquel le circuit de libération (25) peut être commuté, est monté en aval de l'unité d'évaluation.

4. Interrupteur de sécurité selon l'une des revendications 1 à 3, **caractérisé en ce qu'**il est prévu deux bobines de réception (7) qui peuvent être couplées de manière inductive avec la bobine de déclencheur (12), le circuit de libération (25) ne pouvant être commuté que lorsqu'un signal est fourni par chacune des deux bobines de réception (7) et qu'aucun signal n'était présent auparavant.

5. Interrupteur de sécurité selon l'une des revendications 1 à 4, **caractérisé en ce qu'**un interrupteur (26) pouvant être actionné par l'intermédiaire du capteur de Hall (9) est prévu dans le circuit d'émission, le signal cadencé produit par le générateur de signaux cadencés (4) pouvant être libéré à la bobine de réception (7) par l'intermédiaire du capteur de Hall (9).

6. Interrupteur de sécurité selon l'une des revendications 1 à 5, **caractérisé en ce que** le circuit d'émission est relié à l'unité d'évaluation.

7. Interrupteur de sécurité selon l'une des revendications 1 à 6, **caractérisé en ce que** la bobine de réception (7) peut être couplée de manière inductive indirectement avec la bobine du déclencheur (12), le déclencheur (2) comprenant un circuit de réception du déclencheur (11) avec la bobine de déclencheur (12) et un circuit d'émission du déclencheur (14) couplé audit circuit de réception, pouvant être couplé de manière inductive avec la bobine de réception.

8. Interrupteur de sécurité selon la revendication 7, **caractérisé en ce que** le circuit d'émission du déclencheur (14) est couplé avec le circuit de réception du déclencheur (11) par l'intermédiaire d'un circuit de modification (17), de façon que le circuit d'émission du déclencheur (14) émette un signal cadencé modifié.

9. Interrupteur de sécurité selon la revendication 8, **caractérisé en ce qu'**un signal cadencé produit par le générateur de signaux cadencés (4) et le signal cadencé modifié reçu par le circuit de réception peuvent être amenés à l'unité d'évaluation qui commande le circuit de libération (25), lorsque les deux signaux cadencés sont dans un rapport de fréquence prédéterminé.

10. Interrupteur de sécurité selon la revendication 8 ou 9, **caractérisé en ce que** l'unité d'évaluation comprend deux étages de formation d'impulsions et de comptage (21, 22) montés en parallèle, dont l'un est conçu pour traiter et additionner le signal cadencé produit par le générateur de signaux cadencés (4) et l'autre pour traiter et additionner le signal cadencé modifié.

11. Interrupteur de sécurité selon la revendication 10, **caractérisé en ce que** l'unité d'évaluation comprend un étage de comparaison (23) qui est monté en aval des étages de formation d'impulsions et de comptage (21, 22) et ne délivre un signal de sortie que lorsque les états de compteurs des étages de formation d'impulsions et de comptage (21, 22) sont dans un rapport de fréquence prédéterminé.

12. Interrupteur de sécurité selon la revendication 11, **caractérisé en ce qu'**un signal pouvant être libéré par l'intermédiaire du capteur de Hall (9) peut être amené à l'étage de relais (24) par l'intermédiaire d'un canal et le signal de sortie de l'étage de comparaison (23) peut être amené à l'étage de relais (24) par l'intermédiaire d'un autre canal, le circuit de libération (25) ne pouvant être commuté par l'étage de relais (24) que lorsqu'un signal est présent aux deux canaux et qu'aucun signal n'était présent auparavant aux deux canaux.

13. Interrupteur de sécurité selon l'une des revendications 5 à 11, **caractérisé en ce que** le signal cadencé produit par le générateur de signaux cadencés (4), qui peut être libéré par l'intermédiaire du capteur de Hall (9), peut être amené à l'étage de relais (24) par l'intermédiaire d'une entrée et le signal cadencé modifié reçu par le circuit de réception peut être amené à l'étage de relais (24) par l'intermédiaire d'un autre canal, le circuit de libération (25) ne pouvant être commuté par l'étage de relais (24) que lorsqu'un signal est présent aux deux canaux et qu'aucun signal n'était présent auparavant aux deux canaux.

14. Interrupteur de sécurité selon l'une des revendications 11 à 13, **caractérisé en ce que** l'étage de comparaison (23) est conçu de façon à interroger les états de compteurs des étages de formation d'impulsions et de comptage (21, 22) après un intervalle de temps constant, choisi de manière appropriée.

15. Interrupteur de sécurité selon la revendication 14, **caractérisé en ce que** l'étage de comparaison (23) est conçu de façon qu'il ne délivre un signal de sortie à l'étage relais (24) que lorsque les états de compteurs des étages de formation d'impulsions et de comptage (21, 22) diffèrent d'une valeur prédéterminée.

16. Interrupteur de sécurité selon l'une des revendications 8 à 15, **caractérisé en ce que** le circuit de modification (17) est un diviseur de fréquence qui divise par un facteur prédéterminé un signal cadencé reçu par le circuit de réception du déclencheur (11).

17. Interrupteur de sécurité selon la revendication 16, **caractérisé en ce que** l'étage de formation d'impulsions et de comptage (21) n'est interrogé qu'après un intervalle de temps plus long que l'étage de formation d'impulsions et de comptage (22) du facteur du circuit de modification (17) et l'étage de comparaison (23) ne fournit un signal de sortie à l'étage de relais (24) que lorsque les deux états de compteurs reçus sont identiques.

18. Interrupteur de sécurité selon la revendication 16, **caractérisé en ce que** les étages de formation d'impulsions et de comptage (21, 22) sont prévus de façon à rééquilibrer par une modulation différente la fréquence différente entre signal libéré et signal modifié.

19. Interrupteur de sécurité selon l'une des revendications 8 à 18, **caractérisé en ce que** le circuit de modification (17) est prévu pour que la différence de fréquence entre le générateur de signaux cadencés (4) et le signal cadencé modifié soit grande par rapport à la fréquence du signal cadencé produit par le générateur de signaux cadencés (4).

20. Interrupteur de sécurité selon l'une des revendications 1 à 19, **caractérisé en ce qu'**un filtre passe-bande (19) monté en aval de la bobine de réception (7) ne laisse passer que le signal cadencé éventuellement modifié.

21. Interrupteur de sécurité selon l'une des revendications 1 à 20, **caractérisé en ce qu'**au moins un amplificateur (20) est monté en amont de l'unité d'évaluation.

22. Interrupteur de sécurité selon l'une des revendications 1 à 21, **caractérisée en ce que** le capteur de Hall (9) peut être réglé.

23. Interrupteur de sécurité selon l'une des revendications 1 à 22, **caractérisé en ce que** l'aimant (10) est un aimant permanent.

24. Interrupteur de sécurité selon l'une des revendications 1 à 23, **caractérisé en ce que** l'unité d'interrupteur (1) est disposé sur la partie verrouillable (A) et le déclencheur (2) sur la partie se fermant (B).
